# EUROPEAN PATENT APPLICATION

(11) **EP 0 609 528 A1**
(43) Date of publication of application: **10.08.1994**
(21) Application number: 93120273.3
(22) Date of filing: 16.12.1993
(51) Int. Cl.: H01L 25/07, H01L 23/498, H01L 23/31

(54) **Low inductance semiconductor package**

(30) Priority: 01.02.1993 US 11575
(71) Applicant: MOTOROLA, INC., Schaumburg, IL 60196 (US)
(72) Inventor: Pinder, Brent W., Tempe Arizona 85282 (US); Berringer, Kenneth A., Scottsdale, Arizona 85257 (US)
(74) Representative: Hudson, Peter David

(57) **Abstract**

A low inductance semiconductor package (33) for housing at least two semiconductor die comprising a heat sink (11), an insulative material (13), a plurality of package leads (22), a frame (19), a cap (21), and an encapsulation material (23). At least three parallel metal stripes (26-29) are patterned on a surface (15) of the insulative material (13) providing interconnect for the at least two semiconductor die. Each of the plurality of package leads (22) directly connect to a corresponding metal stripe of the at least three metal stripes (26-29) minimizing parasitic inductance.

## Description

### Background of the Invention

This invention relates, in general, to semiconductor packages, and more particularly to semiconductor packages for power transistors.

Processing technology has greatly enhanced the performance of power transistors. Power transistors currently on the market can withstand thousands of volts, conduct hundreds of amps, and operate at higher frequencies. The dramatic increase in performance of these devices places severe constraints on the performance characteristics of the package in which they are placed. In fact, many of the packages currently used limit performance and reliability of the devices.

A packaged high current/high voltage transistor is generally formed from more than one power transistor die or semiconductor die. The package is essential for protecting the power transistor die from an external environment but also adds parasitic capacitance, inductance, and resistance which may degrade performance. The power transistor package may house other components that may be needed such as protection diodes or resistors. These additional components enhance reliability of the packaged power transistor.

There are many characteristics of the package which must be addressed to insure optimal performance. First, the package must be capable of dissipating heat generated by the semiconductor die under worst case conditions. Second, the semiconductor die must be electrically isolated from the heat sink material used to conduct heat away from the semiconductor die. Third, low inductance interconnect is essential for high speed, high current transients. Finally, the package must be easily manufacturable and low cost.

Of particular importance is the inductance of the package. High inductance in series with each input or output (I/O) of a high current/high voltage power transistor (from the package) will absolutely limit performance of a packaged power transistor. For example, 400 amp/600 volt packaged power transistors currently on the market have package I/O inductance ranging from approximately 25 nanohenries to over 50 nanohenries. This type of transistor operates at switching frequencies approaching 20 kilohertz. Inductance numbers in the range listed above generate overshoot voltages ranging from approximately 47 volts to over 60 volts in switching applications. Large overshoot can limit speed and reliability of the transistor and may harm the circuit in which the transistor is used. The problem escalates for larger current and voltage transistors. It would be of great benefit if a power transistor package could be developed which reduces interconnect inductance thereby increasing transistor speed, lowering system noise, and increasing reliability.

### Summary of the Invention

Briefly stated, a low inductance semiconductor package is provided for housing at least two semiconductor die. The low inductance semiconductor package comprises a heat sink, an electrically insulative material coupled to the heat sink, a surface of the insulative material having patterned metal for providing interconnect, at least three parallel metal stripes are formed on the surface, a frame, a cap, a plurality of package leads, and an encapsulation material for holding the package together. The package leads connect directly to a corresponding metal stripe on the surface and extend vertically through the semiconductor package to minimize inductance.

### Brief Description of the Drawings

FIG. 1 is a view of a semiconductor package heat sink in accordance with the present invention;
FIG. 2 is a perspective view of FIG. 1 including package leads and a cutaway view of a cap in accordance with the present invention; and
FIG. 3 is further illustration of the semiconductor package of FIG. 2 including a frame and an encapsulation material in accordance with the present invention.

### Detailed Description of the Drawings

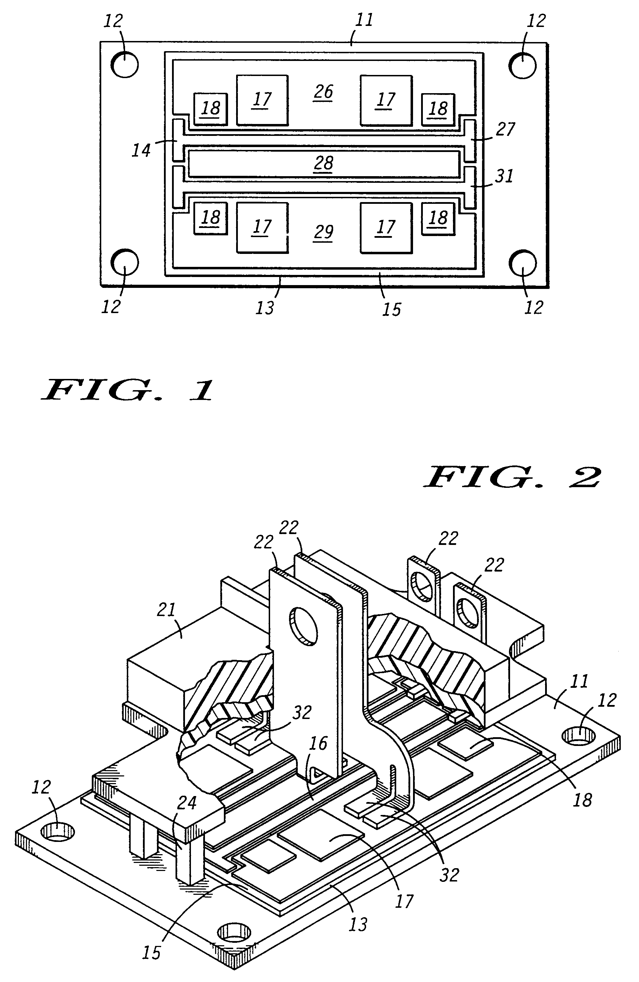

FIG. 1 is a perspective view of a heat sink 11 and an electrically insulative material 13 of a semiconductor package in accordance with the present invention.

A semiconductor package for housing multiple semiconductor die, such as high voltage/high current power transistors, must minimize any parasitic resistance, capacitance, and inductance which could degrade performance. It is well known by those skilled in the art that minimizing distances between connection points, in general, reduces performance degrading parasitics within a package. This principle is used extensively in FIG. 1.

Heat sink 11 is a metal plate for conducting heat away from the semiconductor package. Heat sink 11 has a plurality of openings 12 formed in each corner for mounting the semiconductor package. An electrically insulative material 13 is fastened to heat sink 11. Insulative material 13 is heat conductive and is shown as a rectangular single sheet. In the preferred embodiment, insulative material 13 is made from aluminum nitride or some material having similar properties.

Insulative material 13 has a first surface 15 and a second surface (not shown). In the preferred embodiment, a metal layer is direct bonded to first surface 15 and the second surface. For example, it is well known that copper can be directly bonded to aluminum nitride. The metal layer of copper is direct bonded to insulative material 13 at temperatures approaching 1000 degrees centigrade. This allows a low temperature process such as soldering to be used on the metal layers later in the manufacturing flow without degrading the bond integrity of the metal layer to insulative material 13.

The metal layer on the second surface (not shown) is used to fasten insulative material 13 to heat sink 11. Solder couples the metal layer to heat sink 11 holding insulative 13 to heat sink 11. The metal layer on the second surface is not essential but simplifies manufacturing. Other bonding agents could be used to couple fasten insulative material 13 to heat sink 11 such as epoxy.

Fastening multiple sheets of insulative material 13 to heat sink 11 is an alternative to using a single sheet as illustrated in FIG. 1. Under extreme thermal conditions, localized heating and other factors can induce stress on the single sheet of insulative material 13 such that it may fracture. Using separate smaller sheets can minimize stress and fracturing.

The metal layer on first surface 15 of insulative material 13 is patterned to provide interconnect for semiconductor die housed in the semiconductor package. A plurality of metal areas comprising metal areas 26, 27, 28, and 29 and a Kelvin contact 31 form low resistance interconnect for a plurality power transistor die 17 and a plurality of protection diodes 18. It is understood that power transistor die 17 and protection diodes 18 are shown for discussion purposes only and is not a true representation. The width and shape of metal areas 26, 27, 28, 29, and Kelvin contact 31 may vary depending on the specific application in which they are used and each are electrically isolated from one another. In the preferred embodiment metal areas 26, 27, 28, 29, and Kelvin contact 31 are formed in parallel metal stripes to provide interconnect across the length of insulative material 13 and provide central connection points to minimize parasitic resistance, capacitance, and inductance.

In general, parallel coupled power transistors are used to form a single large device. Illustrated in FIG. 1 is a typical configuration comprising power transistor die 17 and protection diodes 18 each having a surface bonded to respective metal areas 26 and 29. Power transistor die 17 have a control terminal, a first electrode, and a second electrode. Protection diodes 18 have a first electrode and a second electrode. The first and second electrodes of power transistor die 17 conduct substantial current. The first electrode of each power transistor die 17 and each protection diode 18, are physically and electrically coupled to either metal area 26 or 29 through the bonded surface. The second electrode and control electrode of each power transistor die 17 and the second electrode of protection diodes 18 have terminals or metal pads on the exposed surface for external coupling. Wire bonding is used to couple metal pads of power transistor die 17 to corresponding metal areas on first surface 15. For example, a metal pad or pads coupled to the control electrode of each power transistor die 17 is wire bonded to metal area 27. Also, the metal pads coupling to the second electrode of each power transistor die 17 is wire bonded to metal area 28. Current limitations of the wire may require multiple wire bonds for coupling the second electrode of power transistor die 17 to metal area 28.

Mounting power transistor die 17 on the peripheral metal areas 26 and 29 simplifies wire bonding by placing metal areas 27, 28 and Kelvin contact 31 central to, and in close proximity to all semiconductor die. Forming metal areas 26-29 and Kelvin contact 31 as parallel metal stripes provides area for wire bonding sufficient for each semiconductor die and reduces wire bond length. Also, power transistor die 17 are located centrally on insulative material 13 to minimize distance to package leads (not shown). Kelvin contact 31 is coupled to a low current output from each power transistor die 17. Kelvin contact 31 is generally used for compensation or sensing.

FIG. 2 is a perspective view of the semiconductor package of FIG. 1 further including a cap 21 and a plurality of package leads 22. Cap 21 is cutaway to show details of heat sink 11.

Plurality of package leads 22 provides interconnect external to the semiconductor package. Plurality of package leads 22 couple to metal areas 26-29 and Kelvin contact 31. Each package lead is directly connected to a corresponding metal area in a substantially vertical direction to minimize the length of package lead 22. Cap 21 is supported a predetermined distance above heat sink 11 by a plurality of support structures 24. Plurality of support structures 24 extend from cap 21, suspending cap 21 above heat sink 11.

Each package lead 22 has at least one flange 32 bent for coupling to a corresponding metal area (metal areas 26-29 and Kelvin contact 31). In the preferred embodiment, each flange 32 is soldered to the corresponding metal area on insulative material 13 providing a physical and electrical connection. Note that the high current connections (the first and second electrodes of power transistor die 17) couple at points centrally located and in close proximity to power transistor die 17 to minimize parasitic resistance, capacitance, and inductance. The direct connection of package leads 22 to the corresponding metal areas on first surface 15 of insulative material 13 simplifies manufacturing by eliminating the need for wiring. In the preferred embodiment, all metal of the semiconductor package is nickel plated to prevent corrosion and oxidation.

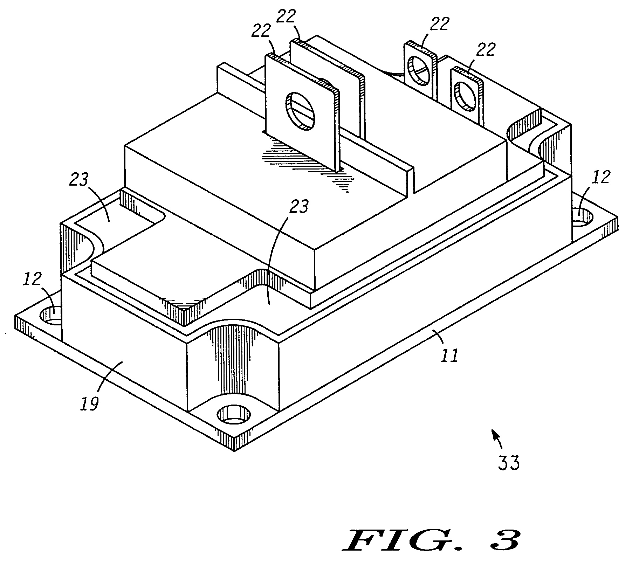

FIG. 3 is a further illustration of the semiconductor package of FIG. 2 in accordance with the present invention.

A frame 19 and encapsulation material 23 is added to the components shown in FIG. 2 to form semiconductor package 33. Frame 19 protects area between heat sink 11 and cap 21 from the external environment. In the preferred embodiment, encapsulation material 23 comprises two different materials. A layer of silicone is formed in frame 19 and a layer of epoxy is placed on the silicone layer. Both the silicone and epoxy hold heat sink 11, frame 19, and cap 21 together. The silicone layer allows elements such as wire bonds to flex or move under operating conditions. Package leads 22 extend through cap 21 providing external connection points from the semiconductor die housed in package 33.

By now it should be appreciated that a semiconductor package having low inductance has been presented. The semiconductor package is capable of housing at least two semiconductor die and minimizes inductance by centrally locating the semiconductor die and package leads thus eliminating unnecessary wire interconnect.

## Claims

1. A low inductance semiconductor package 33 for housing at least two semiconductor die 17 comprising:
a heat sink 11;
an electrically insulative material 13 disposed on and contiguous to said heat sink 11;
at least three parallel metal stripes (26, 28, 29) patterned on a first surface 15 of said insulative material 13 for providing interconnect, said at least three metal stripes (26, 28, 29) are electrically isolated from one another;
a frame 19;
a cap 21;
a plurality package leads 22 providing interconnect external to the semiconductor package 33, each package lead 22 directly connects to a corresponding metal stripe (26, 28, 29) in a substantially vertical direction; and
an encapsulation material 23 for coupling said heat sink 11, frame 19, and cap 21 together.

2. The package of claim 1 wherein said insulative material 13 having a metal layer coupled to a second surface, said metal layer is soldered to said heat sink fastening said electrically insulative material to said heat sink.

3. The package of claim 1 wherein said insulative material 13 is heat conductive.

4. The package of claim 1 wherein said insulative material 13 comprises aluminum nitride.

5. The package of claim 1 wherein said insulative material 13 coupled to said surface of said heat sink 11 comprises at least two separate sheets to reduce stress on said insulative material 13.

6. The package of claim 1 wherein said cap 21 having a plurality of support structures to suspend said cap 21 a predetermined distance from said heat sink 11.

7. The package of claim 1 wherein said encapsulation material 23 comprises a layer of silicone and a layer of epoxy.

8. A low inductance semiconductor package 33 for housing at least two semiconductor die 17 comprising:
a heat sink 11;
an electrically insulative material 13 coupled to said heat sink 11, said insulative material 13 is heat conductive, said insulative material 13 having a metal layer coupled to a first surface, said metal layer is soldered to said heat sink 11 fastening said insulative material 13 to said heat sink 11;
at least three metal areas (26, 28, 29) patterned on a second surface 15 of said insulative material 13 providing interconnect for the at least two semiconductor die 17, said at least three metal areas (26, 28, 29) are electrically isolated from one another;
a Kelvin contact 31 on said second surface 15 of said insulative material 13;
a frame 19;
a cap 21;
a plurality of package leads 22 providing interconnect external to the semiconductor package 33, each package lead connects to a corresponding metal area on said second surface 15 of said insulative material 13 in a substantially vertical direction; and
an encapsulation material 23 for coupling said heat sink 11, frame 19, and cap 21 together.

9. The package of claim 8 wherein said at least three metal areas (26, 28, 29) are formed as parallel metal stripes on said second surface 15 of said insulative material 13.

10. The package of claim 8 wherein said insulative material 13 comprises aluminum nitride.
